# EUROPEAN PATENT APPLICATION

(11) **EP 4 718 654 A1**
(43) Date of publication of application: **01.04.2026**
(21) Application number: 25184884.2
(22) Date of filing: 24.06.2025
(51) Int. Cl.: H02H 7/18, H02H 3/20, H02J 7/00, G01R 19/165, G01R 19/25

(54) **VOLTAGE DETECTION CIRCUIT AND VOLTAGE DETECTION METHOD**

(30) Priority: 25.09.2024 CN 202411345737; 25.09.2024 CN 202422354182 U
(71) Applicant: Eve Energy Co., Ltd., Huizhou, Guangdong 516006 (CN)
(72) Inventor: HU, Jun, Huizhou, Guangdong, 516006 (CN); SHEN, Ruizhang, Huizhou, Guangdong, 516006 (CN)
(74) Representative: Herrero & Asociados, S.L.

(57) **Abstract**

A voltage detection circuit (1) and a voltage detection method are provided. The voltage detection circuit (1) includes a voltage conversion module (10), a logic processing module (20), and a high-side driver module (30). The voltage conversion module (10) is configured to convert an analog signal corresponding to a target voltage of a target battery cell into a target voltage digital quantity. The logic processing module (20) is connected to the voltage conversion module (10) and configured to output a target signal to the high-side driver module (30) based on a comparison detection result between a preset threshold and the target voltage digital quantity. The high-side driver module (30) is connected to the logic processing module (20) and configured to determine whether to cut off an external power supply based on the target signal.

## Description

### TECHNICAL FIELD

The present disclosure relates to the field of voltage detection technologies, and in particular, to a voltage detection circuit and a voltage detection method.

### BACKGROUND

Cell voltage detection, diagnosis, and protection are basic demands of a battery management system (BMS), which can ensure the safety of the BMS and prevent thermal runaway.

However, detection and diagnosis functions and a protection function are generally implemented by a combination of a plurality of different IC function circuits, for example, one is responsible for a collection diagnosis function, and the other is responsible for a protection execution function. This manner has high costs and design difficulty, and high frequency of failure, resulting in poor reliability of cell voltage detection, diagnosis and protection.

With regard to the situation in related technologies that the reliability of the cell voltage detection, diagnosis, and protection is poor due to the fact that the cell current detection, diagnosis, and protection are realized by different IC functional circuits, no effective solution has been proposed at present.

### SUMMARY

According to a first aspect, the present disclosure provides a voltage detection circuit. The voltage detection circuit includes a voltage conversion module, a logic processing module, and a high-side driver module. The voltage conversion module is configured to convert an analog signal corresponding to a target voltage of a target battery cell into a target voltage digital quantity. The logic processing module is connected to the voltage conversion module and configured to output a target signal to the high-side driver module based on a comparison detection result between a preset threshold and the target voltage digital quantity. The high-side driver module is connected to the logic processing module and is configured to determine whether to cut off an external power supply based on the target signal.

According to a second aspect, the present disclosure provides a voltage detection method. The method includes: converting, by a voltage conversion module, an analog signal corresponding to a target voltage of a target battery cell into a target voltage digital quantity; outputting, by a logic processing module, a target signal to a high-side driver module based on a comparison detection result between a preset threshold and the target voltage digital quantity; and determining, by the high side driver module, whether to shut off an external power supply based on the target signal.

The beneficial effects provided in the present disclosure are as follows: by means of the present disclosure, the following device is adopted: the voltage conversion module is configured to convert an analog signal corresponding to a target voltage of a target battery cell into a target voltage digital quantity; the logic processing module is connected to the voltage conversion module and the high-side driver module, respectively, the logic processing module is configured to output a target signal to the high-side driver module based on a comparison detection result between a preset threshold value and the target voltage digital quantity; the high-side driver module is configured to determine whether to cut off an external power supply based on the target signal, thereby solving the problem in the related technologies that the reliability of cell voltage detection, diagnosis, and protection is poor due to the fact that the cell voltage detection, diagnosis, and protection are realized by different IC functional circuits. In this solution, the voltage conversion module converts an analog signal corresponding to a voltage of a target battery cell into a target voltage digital quantity, then the logic processing module outputs a target signal to the high-side driver module based on a comparison detection result between a preset threshold value and the target voltage digital quantity, finally, the high-side driver module determines whether to cut off an external power supply based on the target signal. The voltage detection circuit realizes the cell voltage detection, diagnosis and protection by an integration of the voltage conversion module, the logic processing module and the high-side driver module, thereby achieving the effect of improving the reliability of the cell voltage detection, diagnosis, and protection.

### BRIEF DESCRIPTION OF THE DRAWINGS

FIG. 1 is a first schematic diagram of a voltage detection circuit according to embodiments of the present disclosure;
FIG. 2 is a second schematic diagram of a voltage detection circuit according to the embodiments of the present disclosure;
FIG. 3 is a first schematic diagram of a voltage conversion module according to the embodiments of the present disclosure;
FIG. 4 is a second schematic diagram of a voltage conversion module according to the embodiments of the present disclosure;
FIG. 5 is a third schematic diagram of a voltage conversion module according to the embodiments of the present disclosure;
FIG. 6 is a third schematic diagram of a voltage detection circuit according to the embodiments of the present disclosure;
FIG. 7 is a schematic diagram of a logic processing module according to the embodiments of the present invention;
FIG. 8 is a fourth schematic diagram of a voltage detection circuit according to the embodiments of the present disclosure;
FIG. 9 is a fifth schematic diagram of a voltage detection circuit according to the embodiments of the present disclosure;
FIG. 10 is sixth schematic diagram of a voltage detection circuit according to the embodiments of the present disclosure;
FIG. 11 is a schematic diagram of a booster pump according to the embodiments of the present disclosure;
FIG. 12 is a flowchart of a voltage detection method according to the embodiments of the present disclosure.

Reference numerals: 1, voltage detection circuit; 10, voltage conversion module; 20, logic processing module; 30, high-side driver module; 100, analog modulation module; 101, digital filter module; 102, digital correction module; 1000, first switch; 1001, analog modulator; 1010, digital filter; 1011, first digital signal processor; 1020, digital corrector; 1021, second digital signal processor; 1022, second switch; 200, electronic buffer; 201, logic gate module; 202, CRC generator; 2010, serial peripheral interface; 2011, register; 2012, logic gate; 40, boost module; 400, charging pump; 401, under-voltage/over-voltage protection module.

### DETAILED DESCRIPTION

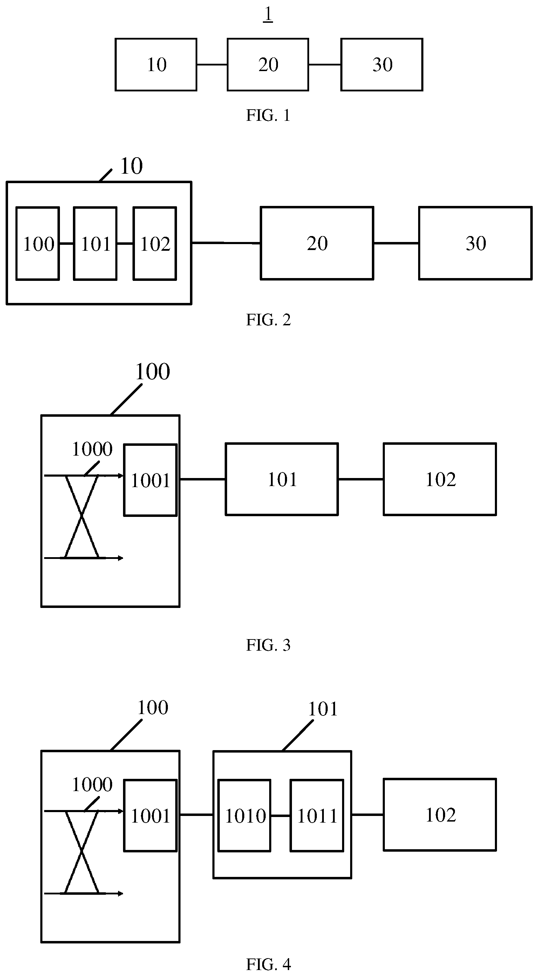

FIG. 1 is a first schematic diagram of a voltage detection circuit according to the embodiments of the present disclosure. As shown in FIG. 1, the voltage detection circuit 1 includes a voltage conversion module 10, a logic processing module 20 and a high-side driver module 30.

The voltage conversion module 10 is configured to convert an analog signal corresponding to a target voltage of a target battery cell into a target voltage digital quantity.

The logic processing module 20 is connected to the voltage conversion module 10 and the high-side driver module 30, respectively. The logic processing module 20 is configured to output a target signal to the high-side driver module 30 based on a comparison detection result between a preset threshold value and the target voltage digital quantity.

The high-side driver module 30 is configured to determine whether to cut off an external power supply based on the target signal.

The analog signal corresponding to the target voltage of the target battery cell is received through the voltage conversion module 10. It should be noted that, the voltage of the target battery cell can be collected by a voltage collection device, and then the collected voltage is input to a receiving pin PIN of the voltage conversion module 10. After receiving the analog signal corresponding to the target voltage of the target battery cell, the voltage conversion module 10 performs discrete quantization filtering on the analog signal to extract a digital signal, and then converts the digital signal obtained into an accurate voltage digital quantity, so as to obtain the target voltage digital quantity.

After obtaining the target voltage digital quantity, the voltage conversion module 10 can transmit the target voltage digital quantity to the logic processing module 20 through a serial peripheral interface (SPI interface). The logic processing module 20 outputs the target signal to the high-side driver module 30 based on the comparison detection result between the preset threshold value and the target voltage digital quantity, that is, the logic processing module 20 performs a threshold judgement, and triggers a response signal to the high-side driver module 30 according to a threshold determination result. The high-side driver module 30 determines, according to the target signal, whether to cut off the external power supply. For example, when the cell voltage value reaches a configured threshold, the high-side driver module 30 is triggered, by a CMD logic control signal, to perform a shutdown action, so as to cut off the external power supply of the battery for protection.

It should be noted that, the CMD logic control signal refers to a logic signal configured to control a switch state of a high-side driver. In an application of the high-side driver, these signals may be controlled through an SPI interface or other communication protocols.

It should be noted that the logic processing module 20 may be implemented by a digital comparator or a voltage detector.

In the present disclosure, the voltage conversion module 10 converts an analog signal corresponding to a voltage of a target battery cell into a target voltage digital quantity, then the logic processing module 20 outputs a target signal to the high-side driver module 30 based on a comparison detection result between a preset threshold value and the target voltage digital quantity, finally, the high-side driver module 30 determines whether to cut off an external power supply based on the target signal. The voltage detection circuit 1 realizes the cell voltage detection, diagnosis and protection by an integration of the voltage conversion module 10, the logic processing module 20 and the high-side driver module 30, thereby achieving the effect of improving the reliability of the cell voltage detection, diagnosis, and protection.

As shown in FIG. 2, in the voltage detection circuit 1 provided in an embodiment of the present disclosure, the voltage conversion module 10 includes an analog modulation module 100, a digital filter module 101, and a digital correction module 102. The analog modulation module 100 is connected to the digital filter module 101 and configured to modulate the analog signal corresponding to the target voltage to obtain a modulated signal. The digital filter module 101 is configured to process the modulated signal to obtain a target digital signal corresponding to the target voltage. The digital correction module 102 is connected to the digital filter module 101 and configured to obtain the target voltage digital quantity based on the target digital signal.

In an embodiment, the analog modulation module 100 may perform discretization processing on the analog signal, and then the digital filter module 101 filters the signal discretized to extract a digital signal, so as to obtain the target digital signal corresponding to the target voltage. In order to improve the accuracy of the digital signal, the digital correction module 102 verifies and encodes the target digital signal to obtain the accurate voltage digital quantity. It should be noted that, in an embodiment, the digital correction module 102 may perform verification encoding on the digital quantity according to parameters configured in a non-volatile memory (NVM), so as to obtain the target voltage digital quantity.

The voltage digital quantity corresponding to the battery cell can be accurately extracted by the analog modulation module 100, the digital filter module 101 and the digital correction module 102.

As shown in FIG. 3, in the voltage detection circuit 1 provided in an embodiment of the present disclosure, the analog modulation module 100 includes a first switch 1000 and an analog modulator 1001 connected to each other. The first switch 1000 is configured to perform filtering control on the voltage received from the target battery cell, so as to input the analog signal corresponding to the target voltage into the analog modulator 1001. The analog modulator 1001 is configured to modulate the analog signal corresponding to the target voltage to obtain the modulated signal.

In an embodiment, when a collected voltage is input to the pin PIN of the voltage conversion module 10 through a voltage collection device, the voltage received from the target battery cell is filtered and controlled through the first switch 1000. It should be noted that, the voltage detection circuit 1 provided in the embodiment of the present disclosure can perform protection control on voltage detection of each cell of the target battery, and input control of the voltage of each cell can be realized through the first switch 1000. The first switch 1000 inputs the analog signal corresponding to the target voltage that has been controlled to the analog modulator 1001, and the analog modulator 1001 modulates the analog signal corresponding to the target voltage to obtain the modulated signal. The voltage detection and protection for each cell of the target battery may be implemented by the above device.

As shown in FIG. 4, in the voltage detection circuit 1 provided in an embodiment of the present disclosure, the digital filter module 101 includes a digital filter 1010 and a first digital signal processor 1011. The digital filter 1010 is connected to the analog modulation module 100 and configured to perform digital filtering on the modulated signal to obtain an initial digital signal corresponding to the target voltage. The first digital signal processor 1011 is connected to the digital filter 1010 and configured to perform averaging processing on the initial digital signal to obtain the target digital signal.

In an embodiment, after the analog modulation module 100 performs discrete quantization processing on the analog voltage signal, the analog modulation module 100 inputs the modulated signal into the digital filter 1010, and the digital filter 1010 filters and extracts the digital signal to obtain the above initial digital signal. Then, the initial digital signal is input into the first digital signal processor 1011, and the first digital signal processor 1011 performs averaging processing on the initial digital signal to obtain the target digital signal. The accuracy of the target digital signal can be effectively improved by the digital filter 1010 and the first digital signal processor 1011.

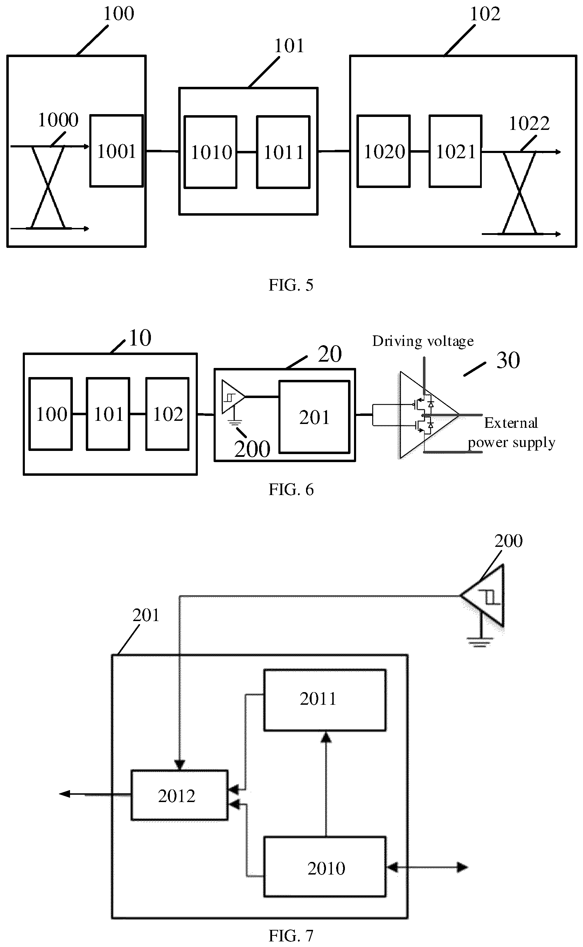

As shown in FIG. 5, in the voltage detection circuit 1 provided in an embodiment of the present disclosure, the digital correction module 102 includes a digital corrector 1020, a second digital signal processor 1021, and a second switch 1022. The digital corrector 1020 is connected to the digital filter module 101 and configured to correct the target digital signal to obtain a corrected digital signal. The second digital signal processor 1021 is connected to the digital corrector 1020 and configured to perform averaging processing on the corrected digital signal to obtain a processed digital signal. The second switch 1022 is connected to the second digital signal processor 1021 and configured to perform filtering control on the processed digital signal to obtain the target voltage digital quantity.

In an embodiment, in order to improve the accuracy of the digital signal, the digital corrector 1020 may verify and encode the digital quantity based on the parameters configured in the NVM to obtain the accurate voltage digital quantity, that is, a corrected digital signal, and then the second digital signal processor 1021 performs averaging processing again on the corrected digital signal to obtain the processed digital signal. It should be noted that, since there are a plurality of cells in the battery, that is, there are a plurality of different voltage values, after obtaining the processed digital signal, it is still need to set the second switch 1022 to perform filtering control, so as to obtain the above-mentioned target voltage digital quantity.

In an embodiment, the voltage conversion module 10 may be further provided with a diagnostic module (DIAG). The accuracy of the voltage value may be monitored and diagnosed by the DIAG. The DIAG may detect whether the voltage conversion module 10 operates normally, whether the voltage exceeds a threshold, etc.

As shown in FIG. 6, in the voltage detection circuit 1 provided in an embodiment of the present disclosure, the logic processing module 20 includes an electronic buffer 200 and a logic gate module 201. The electronic buffer 200 is connected to the logic gate module 201 and configured to receive a control signal to drive the logic gate module 201 to work. The logic gate module 201 is configured to output the target signal to the high-side driver module 30 based on the comparison detection result between the preset threshold value and the target voltage digital quantity.

In an embodiment, after receiving a driving signal, the logic gate module 201 outputs the target signal to the high-side driver module 30 based on the comparison detection result between the preset threshold and the target voltage digital quantity.

As shown in FIG. 7, in the voltage detection circuit 1 provided in an embodiment of the present disclosure, the logic gate module 201 includes a serial peripheral interface 2010, a register 2011 and a logic gate 2012. The serial peripheral interface 2010 is configured to receive the target voltage digital quantity and write the target voltage digital quantity into the register 2011. The register 2011 is configured to store the target voltage digital quantity. The logic gate 2012 is configured to output the target signal to the high-side driver module 30 based on the comparison detection result between the preset threshold and the target voltage digital quantity, that is, the logic gate 2012 performs threshold judgment to output the target signal to the high-side driver module 30. For example, when the cell voltage value reaches a configured threshold, the high-side driver module 30 is triggered, the CMD logic control signal, to perform a shutdown action, so as to cut off the external power supply for protection.

It should be noted that the high-side driver module 30 is composed of field effect transistors.

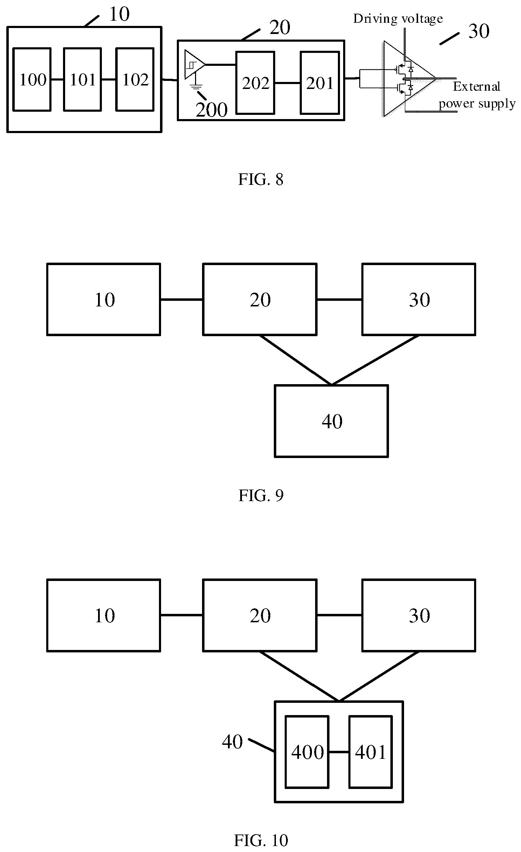

As shown in FIG. 8, in the voltage detection circuit 1 provided in an embodiment of the present disclosure, the logic processing module 20 further includes a cyclic redundancy check (CRC) generator 202 configured to verify the target voltage digital quantity. CRC, that is, a cyclic redundancy check. Data errors are detected and corrected by the CRC generator 202 to prevent inaccurate measurements caused by data transmission or storage errors.

In an embodiment, in order to realize the above high-side driving function, a boost module circuit needs to be provided in the voltage detection circuit 1 provided in the embodiment of the present disclosure, and therefore, as shown in FIG. 9, the voltage detection circuit 1 is further provided with a boost module 40. The boost module 40 is connected to the high-side driver module 30 and the logic processing module 20, respectively. The logic processing module 20 provides a clock signal to the boost module 40 to enable the boost module 40 to output a preset voltage value to the high-side driver module 30, so as to drive the high-side driver module 30 to work based on the preset voltage value. It should be noted that the boost module 40 may be a charging pump boost module circuit. The high-side driver module 30 is driven by the boost module circuit to perform a shutdown action, thereby cutting off external power supply for protection.

As shown in FIG. 10, in the voltage detection circuit 1 provided in an embodiment of the present disclosure, the boost module 40 includes a charging pump 400 and an under-voltage/over-voltage protection module 401. The charging pump 400 is configured to provide the preset voltage value ( that is a driving voltage) for the high-side driver module 30 based on the clock signal output by the logic processing module 20. The under-voltage/over-voltage protection module 401 is configured to protect the boost module 40 when an over-voltage or an under-voltage appears.

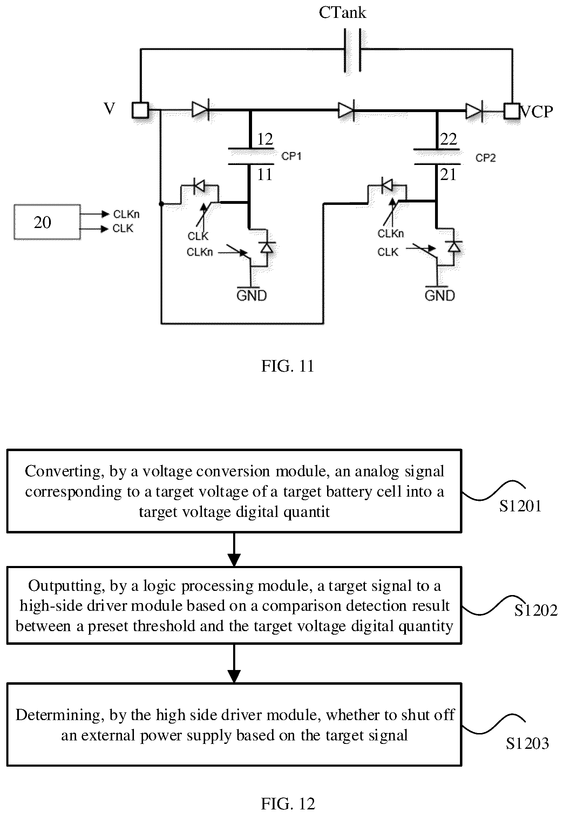

In an embodiment, as shown in a schematic diagram of the charging pump 400 in FIG. 11, the logic processing module 20 outputs switch signals CLKn/CLK. When the signal CLKn is at a high level, the switch CLKn is turned on, a first terminal 11 of a capacitor CP1 is grounded through the turned on switch CLKn, that is, the voltage at the first terminal 11 is V_{CP1-GND}=0; a second terminal 12 of the capacitor CP1 receives an input voltage V through a diode, so that the capacitor CP1 is charged through the input voltage V until the voltage at the second terminal 12 is V_{CP1-V}=V-V_{Diodes}≈V. Similarly, when the signal CLK is at a high level, the switch CLK is turned on, a first terminal 21 of a capacitor CP2 is grounded through the turned on switch CLK, that is, the voltage at the first terminal 21 is V_{CP2-GND}=0; a second terminal 22 of the capacitor CP2 receives the input voltage V through two diodes, so that the capacitor CP2 is charged through the input voltage V until the voltage at the second terminal 22 is V_{CP2-V}=V-2V_{Diodes}≈V.

In this way, when the signal CLKn is at a high level while the CLK signal is at a low level, the switch CLKn is turned on and the switch CLK is turned off. At this time, the voltages at two terminals of the capacitor CP2 undergoes polarity reversal. Due to the fact that a voltage difference between the two terminals of the capacitor CP2 cannot undergo a sudden change, and the first terminal 21 of the capacitor CP2 is connected to the input voltage V through the turned on switch CLKn, that is, the voltage at the first terminal 21 suddenly changes to V'_{CP2-V}=V, thus causing a ground voltage of the capacitor CP2 (i.e. the voltage at the second terminal 22) to suddenly change to V'_{CP2-GND}=V+V_{CP2-V}. Due to the voltage VCP2-V being approximately equal to the input voltage V, the voltage value of V'_{CP2-GND} is approximately twice the input voltage V. In this way, the voltage at the second terminal 22 of the capacitor CP2 will charge a capacitor CTank to increase the voltage VCP. V_{Diodes} is a forward conduction voltage drop of the diode.

Similarly, when the signal CLKn is at a low level while the signal CLK is at a high level, the switch CLKn is turned off and the switch CLK is turned on. At this time, the voltage on two terminals of the capacitor CP1 undergoes polarity reversal. Due to the first terminal 11 of the capacitor CP1 being connected to the input voltage V through the turned on switch CLK, that is, the voltage at the first terminal 11 suddenly changes to V_{'CP1-V}=V, thus causing a ground voltage of the capacitor CP1 (i.e. the voltage at the second terminal 12) suddenly changes to V'_{CP1-GND}=V+V_{CP1-V}. Due to the voltage V_{CP1-V} being approximately equal to the input voltage V, the voltage value of V_{CP1-GND} is approximately twice the input voltage V. In this way, the voltage at the second terminal 12 of the capacitor CP1 will charge the capacitor CTank to increase the voltage VCP. By continuously outputting the switch signals CLKn/CLK through the logic processing module 20, the voltage of the capacitor CTank will finally reach a set voltage value VCP, thereby achieving an internal boost demand of the chip, that is, providing a drive voltage for the high-side driver module 30.

In an optional embodiment, a process of implementing a quantitative reliability analysis method for a voltage detection circuit is as follows:
(1) calculating an overall failure rate of the voltage detection circuit based on an IEC 62380 standard, and decomposing the overall failure rate to obtain failure rates of relevant modules of the voltage detection circuit, which is described in detail in table 1;
(2) analyzing the failure of the cell voltage acquisition, diagnosis, and protection function for the voltage detection circuits through DFMEA, and developing reliability and safety measure mechanisms, such as: SM_01 analog signal self-checking comparison, SM_02 CRC check of calibration parameter download, SM_03 independent CRC generator and detection circuit, SM_04 analog multi-path acquisition switch to a digital-to-analog conversion decoding threshold value self-checking, SM_05 digital-to-analog conversion open circuit diagnosis, SM_06 fault injection self-checking, SM_07 digital-to-analog conversion rationality check, SM_08 charging pump over-voltage and under-voltage diagnosis, SM_09 power supply over-voltage and under-voltage diagnosis, SM_10 analog self-checking, SM_11 drive comparison self-checking; the relevant diagnostic coverage is specified with reference to ISO 26262, please see table 1 for details;
(3) performing quantitative FMEDA analysis on the voltage detection circuit with reference to ISO 26262 standard, and analyzing internal components of an integrated chip of the voltage detection circuit. The measurement mechanism (2) is used to diagnose the failure rate of the components in (1), so that the failure rate of the residual or single point failure is 0.238734 FIT, and the failure rate of potential multi-point failure is 0.17130861 FIT. The analysis process is shown in table 1.

**Table 1:**

| Component Name | Voltage conversion verification diagnosis | Logical processing | High-side drive | Charging pump | Power supply |
|---|---|---|---|---|---|
| Failure rate (FIT) | 1.5068 | 1.3652 | 2.84 | 2.3643 | 15.797 |
| Should reliability and safety related components be considered in calculations? | YES | YES | YES | YES | YES |
| Failure mode | Voltage conversion verification diagnosis failure | Logical processing failure | High-side drive failure | Charging pump failure | Power supply failure |
| Failure distribution (%) | 100 | 100 | 100 | 100 | 100 |
| Remaining reliability safety related failure rate (FIT) | 1.5068 | 1.3652 | 2.84 | 2.3643 | 15.797 1 |
| Failure modes that violate safety objectives in the absence of reliable safety mechanisms? | YES | YES | YES | YES | YES |
| Safety mechanism to prevent failure modes from violating reliability and safety objectives? | SM_07, SM_05 | SM_02, SM_03 | SM_01, SM_11 | SM_08 | SM_09 |
| Coverage rate of failure mode diagnosis in violation of reliability and safety objectives (%) | 99.0 | 99.0 | 99.0 | 99.0 | 99.0 |
| Failure rate (FIT) of residual or single point failure | 0.015068 | 0.013652 | 0.0284 | 0.023643 | 0.1579 71 |
| May failure modes that violate reliability and safety objectives be combined with independent failures of other components? | YES | NO | NO | NO | YES |
| Safety mechanism to prevent potential failure modes? | SM_04, SM_06 | - | - | - | SM_10 |
| Coverage rate of potential failure modes (%) | 99.0 | - | - | - | 99.0 |
| Potential multi-point failure rate (FIT) | 0.0149173 | - | - | - | 0.1563 913 |

In the voltage detection circuit provided in the embodiments of the present disclosure, the voltage conversion module is configured to convert an analog signal corresponding to a target voltage of a target battery cell into a target voltage digital quantity; the logic processing module is connected to the voltage conversion module and the high-side driver module, respectively, the logic processing module is configured to output a target signal to the high-side driver module based on a comparison detection result between a preset threshold value and the target voltage digital quantity; the high-side driver module is configured to determine whether to cut off an external power supply based on the target signal, thereby solving the problem in the related technologies that the reliability of cell voltage detection, diagnosis, and protection is poor due to the fact that the cell voltage detection, diagnosis, and protection are realized by different IC functional circuits. In this solution, the voltage conversion module converts an analog signal corresponding to a voltage of a target battery cell into a target voltage digital quantity, then the logic processing module outputs a target signal to the high-side driver module based on a comparison detection result between a preset threshold value and the target voltage digital quantity, finally, the high-side driver module determines whether to cut off an external power supply based on the target signal. The voltage detection circuit realizes the cell voltage detection, diagnosis and protection by an integration of the voltage conversion module, the logic processing module and the high-side driver module, thereby achieving the effect of improving the reliability of the cell voltage detection, diagnosis, and protection.

FIG. 12 is a flowchart of a voltage detection method according to the embodiments of the present disclosure. As shown in FIG. 12, the method includes:
step S1201, converting, by a voltage conversion module 10, an analog signal corresponding to a target voltage of a target battery cell into a target voltage digital quantity;
step S1202, outputting, by a logic processing module 20, a target signal to a high-side driver module 30 based on a comparison detection result between a preset threshold value and the target voltage digital quantity;

Step S1203, determining, by the high-side driver module 30, whether to cut off an external power supply based on the target signal.

The analog signal corresponding to the target voltage of the target battery cell is received through the voltage conversion module. It should be noted that, the voltage of the target battery cell can be collected by a voltage collection device, and then the collected voltage is input to a receiving pin PIN of the voltage conversion module. After receiving the analog signal corresponding to the target voltage of the target battery cell, the voltage conversion module performs discrete quantization filtering on the analog signal to extract a digital signal, and then converts the digital signal obtained into an accurate voltage digital quantity, so as to obtain the target voltage digital quantity.

After obtaining the target voltage digital quantity, the voltage conversion module can transmit the target voltage digital quantity to the logic processing module through a serial peripheral interface (SPI interface). The logic processing module outputs the target signal to the high-side driver module based on the comparison detection result between the preset threshold value and the target voltage digital quantity, that is, the logic processing module performs threshold judgement, and triggers a response signal to the high-side driver module according to a threshold determination result. The high-side driver module determines whether to cut off the external power supply according to the target signal. For example, when the cell voltage value reaches a configured threshold, the high-side driver module is triggered, by a CMD logic control signal, to perform a shutdown action, so as to cut off the external power supply of the battery for protection.

In an embodiment of the present disclosure, the voltage conversion module 10 includes an analog modulation module 100, a digital filter module 101 and a digital correction module 102. The digital filter module 101 is connected to the analog modulation module 100 and the digital correction module 102, respectively.

The step S1201 specifically includes:
step A, modulating, by the analog modulation module 100, the analog signal corresponding to the target voltage to obtain a modulated signal;
step B, processing, by the digital filter module 101, the modulated signal to obtain a target digital signal corresponding to the target voltage; and
step C, obtaining, by the digital correction module 102, the target voltage digital quantity based on the target digital signal.

In an embodiment of the present disclosure, the analog modulation module 100 includes a first switch 1000 and an analog modulator 1001 connected to the first switch 1000.

The step A specifically includes:
step A1, performing, by the first switch 1000, filtering control on the voltage received from the target battery cell, so as to input the analog signal corresponding to the target voltage to the analog modulator 1001; and
step A2, modulating, by the analog modulator 1001, the analog signal corresponding to the target voltage to obtain the modulated signal.

In an embodiment of the present disclosure, the digital filter module 101 includes a digital filter 1010 and a first digital signal processor 1011. The digital filter 1010 is connected to the analog modulation module 100 and the digital filter 1010.

The step B specifically includes:
step B1, performing, by the digital filter 1010, digital filtering on the modulated signal to obtain an initial digital signal corresponding to the target voltage; and
step B2, performing, by the first digital signal processor 1011, averaging processing on the initial digital signal to obtain the target digital signal.

In an embodiment of the present disclosure, the digital correction module 102 includes a digital corrector 1020, a second digital signal processor 1021, and a second switch 1022. The digital corrector 1020 is connected to the digital filter module 101. The second digital signal processor 1021 is connected to the digital corrector 1020 and the second switch 1022, respectively.

The step C specifically includes:
step C1, correcting, by the digital corrector 1020, the target digital signal to obtain a corrected digital signal;
step C2, performing, by the second digital signal processor 1021, averaging processing on the corrected digital signal to obtain a processed digital signal; and
step C3, performing, by the second switch 1022, filtering control on the processed digital signal to obtain the target voltage digital quantity.

In an embodiment of the present disclosure, the logic processing module 20 includes an electronic buffer 200 and a logic gate module 201. The electronic buffer 200 is connected to the logic gate module 201.

The step S1202 specifically includes:
step D, receiving, by the electronic buffer 200, a control signal to drive the logic gate module 201 to work;
step E, outputting, by the logic gate module 201, the target signal to the high-side driver module 30 based on the comparison detection result between the preset threshold value and the target voltage digital quantity.

In an embodiment of the present disclosure, the logic gate module 201 includes a serial peripheral interface 2010, a register 2011 and a logic gate 2012.

The step E specifically includes:
step E1, receiving, by the serial peripheral interface 2010, the target voltage digital quantity and write the target voltage digital quantity into the register 2011;
step E2, storing, by the register 2011, the target voltage digital quantity; and
step E3, outputting, the logic gate 2012, by the target signal to the high-side driver module 30 based on the comparison detection result between the preset threshold and the target voltage digital quantity.

In an embodiment of the present disclosure, the logic processing module 20 further includes a CRC generator 202.

The step S1202 further specifically includes:
step F, verifying, by the CRC generator 202, the target voltage digital quantity.

In an embodiment of the present disclosure, the voltage detection method further includes:
step G, providing, by the logic processing module 20, a clock signal to a boost module 40 to enable the boost module 40 to output a preset voltage value to the high-side driver module 30, so as to drive the high-side driver module 30 to work based on the preset voltage value.

In an embodiment of the present disclosure, the boost module 40 includes a charging pump 400 and an under-voltage/over-voltage protection module 401.

The voltage detection method further includes:
providing, by the charging pump 400, the preset voltage value for the high-side driver module 30 based on the clock signal output by the logic processing module 20; and
protecting, by the under-voltage/over-voltage protection module 401, the boost module 40.

The embodiments of the present disclosure provide a computer-readable storage medium, on which a program is stored. The program, when executed by a processor, causes the processor to implement the voltage detection method.

The embodiments of the present disclosure provide a processor. The processor is configured to run a program. The voltage detection method is executed when the program is run.

The embodiments of the present disclosure provide an electronic device. The device includes a processor, a memory, and a program stored in the memory and executable by the processor. When the processor executes the program, the voltage detection method is implemented.

Those skilled in the art shall understand that the embodiments of the present disclosure can be provided as a method, a system or a computer program product. Therefore, the present disclosure may take a form of an entirely hardware embodiment, an entirely software embodiment, or an embodiment combining software and hardware. Furthermore, the present disclosure may take a form of a computer program product implemented on one or more computer-readable storage media (including but not limited to a disk memory, a CD-ROM, an optical memory, etc. ) containing computer-readable program codes.

The present disclosure is described with reference to the flowcharts and/or block diagrams of a method, a device (a system), and a computer program product according to the embodiments of the present disclosure. It should be understood that each process and/or block in flowcharts and/or block diagrams, and a combination of processes and/or blocks in the flowcharts and/or block diagrams can be implemented by computer program instructions. These computer program instructions may be provided to a processor of a general-purpose computer, a special-purpose computer, an embedded processor or other programmable data processing devices to produce a machine, so that instructions executed by a processor of a computer or other programmable data processing devices produce a device configured to implement functions specified in one or more processes in the flowcharts and/or one or more blocks in the block diagrams.

These computer program instructions may also be stored in a computer-readable memory capable of guiding a computer or other programmable data processing devices to work in a specific manner, so that the instructions stored in the computer-readable memory produce a manufactured product including an instruction device that implements functions specified in one or more processes in the flowchart and/or one or more blocks in the block diagram.

These computer program instructions may also be loaded onto a computer or another programmable data processing device, causing a series of operational steps to be performed on a computer or other programmable device to produce a computer-implemented process, thus, the instructions executed on the computer or other programmable devices provide steps for implementing the functions specified in one or more processes in the flowcharts and/or one or more blocks in the block diagrams.

In a typical configuration, the computing device includes one or more processors (CPUs), an input/output interface, a network interface, and a memory.

The memory may include a non-permanent memory in a computer readable medium, a random access memory (RAM), and/or a non-volatile memory, such as a read-only memory (ROM) or a flash RAM. A memory is an example of a computer-readable medium.

Computer-readable media, including both permanent and non-permanent, removable and non-removable media, may implement information storage by any method or technology. The information may be computer readable instructions, data structures, program modules, or other data. Examples of computer storage media include, but not limited to phase change memory (PRAM), static random access memory (SRAM), dynamic random access memory (DRAM), other types of random access memory (RAM), read-only memory (ROM), electrically erasable programmable read-only memory (EEPROM), flash memory or other memory technology, compact disc read-only memory (CD-ROM), digital versatile discs (DVD) or other optical storage, magnetic cassettes, magnetic disk storage or other magnetic storage device, or any other non-transmission medium, may be used to store information that may be accessed by a computing device. In the present disclosure, computer-readable media does not include transitory computer-readable media (transitory media), such as modulated data signals and carrier waves.

## Claims

1. A voltage detection circuit (1), comprising:
a voltage conversion module (10) configured to convert an analog signal corresponding to a target voltage of a target battery cell into a target voltage digital quantity;
a logic processing module (20) connected to the voltage conversion module (10) and configured to output a target signal based on a comparison detection result between a preset threshold and the target voltage digital quantity; and
a high-side driver module (30) connected to the logic processing module (20) and configured to determine whether to cut off an external power supply based on the target signal.

2. The voltage detection circuit (1) according to claim 1, wherein the voltage conversion module (10) comprises:
an analog modulation module (100) configured to modulate the analog signal corresponding to the target voltage to obtain a modulated signal;
a digital filter module (101) connected to the analog modulation module (100) and configured to process the modulated signal to obtain a target digital signal corresponding to the target voltage; and
a digital correction module (102) connected to the digital filter module (101) and configured to obtain the target voltage digital quantity based on the target digital signal.

3. The voltage detection circuit (1) according to claim 2, wherein the analog modulation module (100) comprises a first switch (1000) and an analog modulator (1001) connected to the first switch (1000), wherein,
the first switch (1000) is configured to perform filtering control on the voltage received from the target battery cell, so as to input the analog signal corresponding to the target voltage to the analog modulator (1001); and
the analog modulator (1001) is configured to modulate the analog signal corresponding to the target voltage to obtain the modulated signal.

4. The voltage detection circuit (1) according to claim 2, wherein the digital filter module (101) comprises:
a digital filter (1010) connected to the analog modulation module (100) and configured to perform digital filtering on the modulated signal to obtain an initial digital signal corresponding to the target voltage; and
a first digital signal processor (1011) connected to the digital filter (1010) and configured to perform averaging processing on the initial digital signal to obtain the target digital signal.

5. The voltage detection circuit (1) according to claim 2, wherein the digital correction module (102) comprises:
a digital corrector (1020) connected to the digital filter module (101) and configured to correct the target digital signal to obtain a corrected digital signal;
a second digital signal processor (1021) connected to the digital corrector (1020) and configured to perform averaging processing on the corrected digital signal to obtain a processed digital signal; and
a second switch (1022) connected to the second digital signal processor (1021) and configured to perform filtering control on the processed digital signal to obtain the target voltage digital quantity.

6. The voltage detection circuit (1) according to claim 1, wherein the logic processing module (20) comprises an electronic buffer (200) and a logic gate module (201), wherein,
the electronic buffer (200) is connected to the logic gate module (201) and configured to receive a control signal to drive the logic gate module (201) to work;
the logic gate module (201) is configured to output the target signal to the high-side driver module (30) based on the comparison detection result between the preset threshold value and the target voltage digital quantity.

7. The voltage detection circuit (1) according to claim 6, wherein the logic gate module (201) comprises a serial peripheral interface (2010), a register (2011) and a logic gate (2012), wherein,
the serial peripheral interface (2010) is configured to receive the target voltage digital quantity and write the target voltage digital quantity into the register (2011);
the register (2011) is configured to store the target voltage digital quantity; and
the logic gate (2012) is configured to output the target signal to the high-side driver module (30) based on the comparison detection result between the preset threshold and the target voltage digital quantity.

8. The voltage detection circuit (1) according to claim 6, wherein the logic processing module (20) further comprises:
a CRC generator (202) configured to verify the target voltage digital quantity.

9. The voltage detection circuit (1) according to any one of claims 1 to 8, wherein the voltage detection circuit (1) further comprises:
a boost module (40) connected to the high-side driver module (30) and the logic processing module (20), respectively; wherein the logic processing module (20) is configured to provide a clock signal to the boost module (40) to enable the boost module (40) to output a preset voltage value to the high-side driver module (30), so as to drive the high-side driver module (30) to work based on the preset voltage value.

10. The voltage detection circuit (1) according to claim 9, wherein the boost module (40) comprises:
a charging pump (400) configured to provide the preset voltage value for the high-side driver module (30) based on the clock signal output by the logic processing module (20); and
an under-voltage/over-voltage protection module (401) configured to protect the boost module (40).

11. A voltage detection method, comprising:
converting, by a voltage conversion module (10), an analog signal corresponding to a target voltage of a target battery cell into a target voltage digital quantity;
outputting, by a logic processing module (20), a target signal to a high-side driver module (30) based on a comparison detection result between a preset threshold and the target voltage digital quantity; and
determining, by the high side driver module (30), whether to shut off an external power supply based on the target signal.

12. The voltage detection method according to claim 11, wherein the voltage conversion module (10) comprises an analog modulation module (100), a digital filter module (101), and a digital correction module (102); wherein the digital filter module (101) is connected to the analog modulation module (100) and the digital correction module (102), respectively;
wherein the converting, by a voltage conversion module (10), an analog signal corresponding to a target voltage of a target battery cell into a target voltage digital quantity comprises:
modulating, by the analog modulation module (100), the analog signal corresponding to the target voltage to obtain a modulated signal;
processing, by the digital filter module (101), the modulated signal to obtain a target digital signal corresponding to the target voltage; and
obtaining, by the digital correction module (102), the target voltage digital quantity based on the target digital signal.

13. The voltage detection method according to claim 12, wherein the analog modulation module (100) comprises a first switch (1000) and an analog modulator (1001) connected to the first switch (1000);
wherein the modulating, by the analog modulation module (100), the analog signal corresponding to the target voltage to obtain a modulated signal comprises:
performing, by the first switch (1000), filtering control on the voltage received from the target battery cell, so as to input the analog signal corresponding to the target voltage to the analog modulator (1001); and
modulating, by the analog modulator (1001), the analog signal corresponding to the target voltage to obtain the modulated signal.

14. The voltage detection method according to claim 12, wherein the digital filter module (101) comprises a digital filter (1010) and a first digital signal processor (1011); wherein the digital filter (1010) is connected to the analog modulation module (100) and the digital filter (1010);
wherein the processing, by the digital filter module (101), the modulated signal to obtain a target digital signal corresponding to the target voltage comprises:
performing, by the digital filter (1010), digital filtering on the modulated signal to obtain an initial digital signal corresponding to the target voltage; and
performing, by the first digital signal processor (1011), averaging processing on the initial digital signal to obtain the target digital signal.

15. The voltage detection method according to claim 12, wherein the digital correction module (102) comprises a digital corrector (1020), a second digital signal processor (1021), and a second switch (1022); wherein the digital corrector (1020) is connected to the digital filter module (101); the second digital signal processor (1021) is connected to the digital corrector (1020) and the second switch (1022), respectively;
wherein the obtaining, by the digital correction module (102), the target voltage digital quantity based on the target digital signal comprises:
correcting, by the digital corrector (1020), the target digital signal to obtain a corrected digital signal;
performing, by the second digital signal processor (1021), averaging processing on the corrected digital signal to obtain a processed digital signal; and
performing, by the second switch (1022), filtering control on the processed digital signal to obtain the target voltage digital quantity.
